# EUROPEAN PATENT APPLICATION

(11) **EP 2 063 690 A1**
(43) Date of publication of application: **27.05.2009**
(21) Application number: 07828718.2
(22) Date of filing: 28.09.2007
(51) Int. Cl.: H05K 1/02, H05K 7/14

(54) **CORRECTING TOOL FOR USE WITH PRINTED-CIRCUIT BOARD, AND PRINTED-CIRCUIT BOARD UNIT**

(30) Priority: 02.10.2006 JP 2006270982
(71) Applicant: NEC Corporation, Minato-ku Tokyo 108-8001 (JP)
(72) Inventor: MATSUZAWA, Tadashi, Tokyo 108-8001 (JP)
(74) Representative: Vossius & Partner
(86) International application number: PCT/JP2007/068977
(87) International publication number: WO 2008/041633

(57) **Abstract**

Provided is a correcting fitting clamped by elasticity at least on one part of an edge portion of a printed circuit board for correcting warpage or flexure of the printed circuit board. The correcting fitting has a clamping portion for coming into band-shaped abutting contact with both faces of the printed circuit board along the edge portion of the printed circuit board. The clamping portion is bent in such a manner that at least a portion thereof is directed toward the edge portion of the printed circuit board. The bending strength of the correcting fitting against warpage and flexure of the printed circuit board can be enhanced by the clamping portion. Further, since fixing elements such as screws are not used to mount the correcting fitting, the number of parts of the printed circuit board and the number of steps for assembling the same can be reduced to thereby lower cost and achieve high-density packaging.

## Description

### TECHNICAL FIELD

This application claims the benefit of Japanese Patent Application No. 2006-270982 (filed on October 2, 2006), which is hereby incorporated herein by reference in its entirety.

This invention relates to a correcting fitting for preventing flexure or warpage of a printed circuit board. Further, the invention relates to a printed circuit board unit installed in a communication device, by way of example.

### BACKGROUND ART

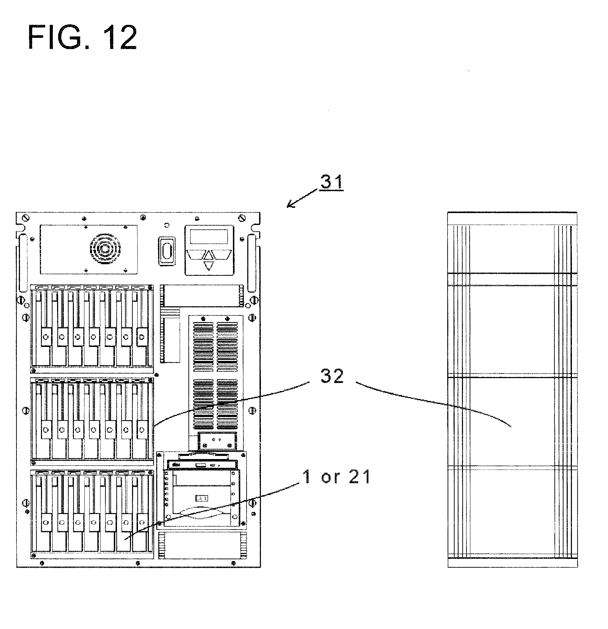

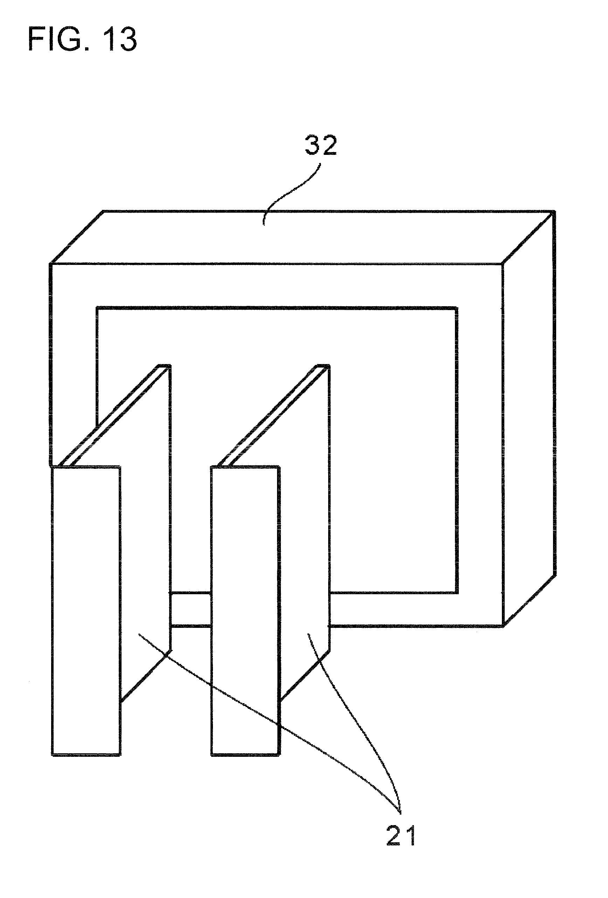

The structure of an ordinary communication device is shown in Fig. 12. In Fig. 12, a communication device 31 is equipped with a shelf 32. The details of the structure of the shelf 32 shown in Fig. 12 is illustrated in Fig. 13. In Fig. 13, cards 21 equipped with electronic circuits are mounted on the shelf 32 electrically and structurally in individual units.

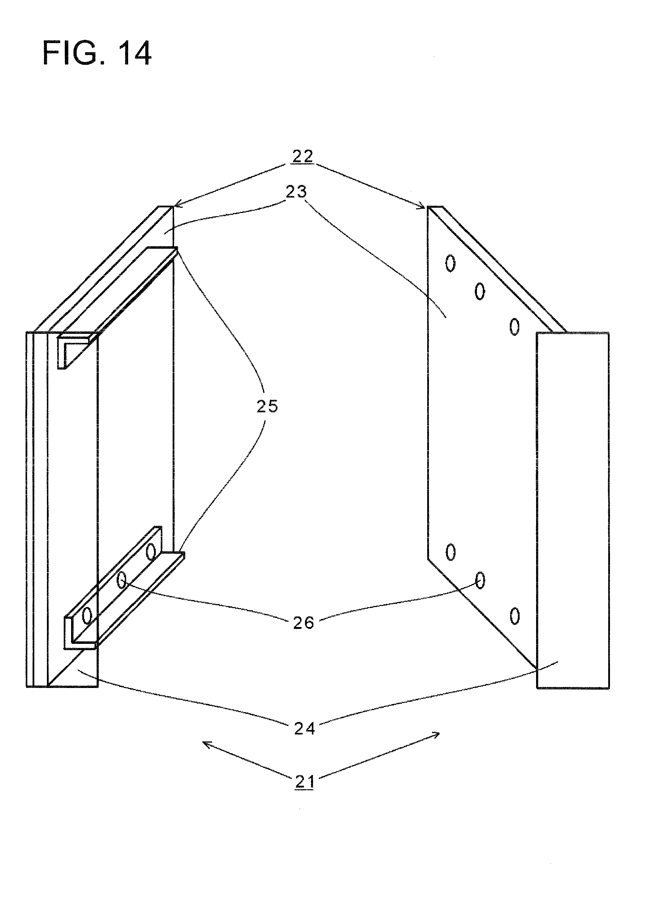

The construction of the cards 21 shown in Fig. 13 relating to the background art is illustrated in Fig. 14 in order to describe the printed circuit board unit and a reinforcing fitting of the printed circuit board according to the background art. In Fig. 14, the card 21 is composed of a printed circuit board 23 equipped with an electronic circuit; L-shaped reinforcing fittings 25 for preventing flexure and warpage of the printed circuit board 23; and a front panel 24 for protecting an LED and connector, etc., on the front portion of the card 21 and for presenting an explanatory display.

In the example of Fig. 14, the reinforcing fixtures 25 are secured on one face of the printed circuit board 23 by screws or rivets 26. By virtue of the reinforcing fixtures 25 thus secured to the printed circuit board 23 by the screws or rivets 26, the printed circuit board 23 is reinforced against flexure and warpage, etc., when the electronic circuit is mounted, when the card is inserted and in the event that heat is produced when the electronic circuit is driven.

Such reinforcement for preventing flexure and warpage of a printed circuit board is described in Patent Documents 1 to 7, by way of example. Patent Document 1 discloses a fitting for preventing warpage of a printed circuit board, the fitting having a pressing portion obtained by bending a leaf-spring member into a U-shape and bending a distal end portion on one side outwardly into an L-shape. Patent Document 2 discloses a printed circuit board in which a Y-shaped stiffener which, owing to its own rigidity, corrects for warpage produced in the printed circuit board is fastened by rivets or the like in a rail-engaging portion. Patent Document 3 discloses a printed circuit board device in which an engagement reinforcing plate for mating with a recess of an electronic-device casing is fixed at both end portions by screws. Patent Document 4 discloses a structure for preventing warpage of a circuit board in which a reinforcing fitting obtained by bending a metal plate into a U-shaped cross section and having a groove is fitted in spring-like fashion onto the edge of a circuit board. Patent Document 5 discloses a package in which warp-preventing rails each having a guide groove into which a guide projection of a shelf is inserted are fixedly provided on upper and lower edges. Patent Document 6 discloses a printed wiring board having a warpage preventing mechanism comprising a fitting consisting of an electrically conductive material formed into a clip shape for clamping the edge portion of a printing wiring board in order to prevent the occurrence of warpage of the printed wiring board. Patent Document 7 discloses a printed circuit board unit structure having an insertion fitting attached by screws along the full length of at least one of upper and lower edges of a printed circuit board unit along the insertion direction thereof.

[Patent Document 1] Japanese Utility Model Kokai Publication No. 62-169760U
[Patent Document 2] Japanese Utility Kokai Publication No. 5-18081U
[Patent Document 3] Japanese Utility Model Kokai Publication No. 5-23588U
[Patent Document 4] Japanese Patent Kokai Publication No. JP-A-4-284692
[Patent Document 5] Japanese Patent Kokai Publication No. JP-A-6-85478
[Patent Document 6] Japanese Patent Kokai Publication No. JP-A-11-330641
[Patent Document 7] Japanese Patent No. 3257337

### DISCLOSURE OF THE INVENTION

### PROBLEMS TO BE SOLVED BY THE INVENTION

It should be noted that the contents disclosed in Patent Documents 1 to 7 are hereby incorporated herein by reference. The present invention offers an analysis of the related art, as set forth below.

The problems set forth below arise in the structures for preventing flexure of a card board in a communication device according to the background art.

In the art described in Patent Documents 2, 3, 5 and 7, a large number of parts and a large number of assembly steps are required in order to secure a warpage correcting fitting to a printed circuit board using screws or rivets. This makes it difficult to lower the cost of the printed circuit board. It is required that areas for mounting screws and rivets, such as screw holes and cut-outs, be reserved on the printed circuit board. This is an impediment in terms of achieving high-density packaging.

Further, in the art described in Patent Documents 1 to 7, if flexure or warpage of a printed circuit board is severe, or if a large load is applied at insertion of a card, there is a possibility that flexure or warpage will not be suppressed fully owing to inadequate strength of the warpage correcting fitting (fitting). For example, at the L-shaped bend in the warpage preventing fitting described in Patent Document 1, there are cases where it is difficult to maintain the shape thereof against the stress produced by warpage of the printed circuit board, and there is the danger that the function for preventing warpage of the printed circuit board will not manifest itself.

It is an object of the present invention to provide a correcting fitting for preventing flexure and warpage of a printed circuit board when an electronic circuit is mounted, when a card is inserted or in the event that heat is produced when the electronic circuit is driven, as well as a printed circuit board unit using this correcting fitting, wherein the correcting fitting can be attached to the printed circuit board in simple fashion, cost can be lowered by reducing the number of parts of the printed circuit board and assembly steps and it is possible to achieve high-density packaging of electronic circuits on the printed circuit board.

### MEANS FOR SOLVING THE PROBLEM

In accordance with a first aspect of the present invention, there is provided a correcting fitting clamped by elasticity at least on one part of an edge portion of a printed circuit board for correcting warpage or flexure of the printed circuit board, the correcting fitting having a clamping a portion for coming into band-shaped abutting contact with both faces of the printed circuit board along the edge portion of the printed circuit board, the clamping portion being bent in such a manner that at least a portion thereof is directed toward the edge portion of the printed circuit board.

In accordance with a preferred exemplary embodiment of the first aspect, the clamping portion is formed by folding back a plate-shaped member a plurality of times.

According to a preferred exemplary embodiment of the first aspect, the clamping portion is formed by imparting a plate-shaped member with a cylindrical shape.

In accordance with a second aspect of the present invention, there is provided a correcting fitting clamped by elasticity at least on one part of an edge portion of a printed circuit board for correcting warpage or flexure of the printed circuit board, the correcting fitting having a clamping portion for coming into band-shaped abutting contact with both faces of the printed circuit board along the edge portion of the printed circuit board, the clamping portion being thicker than other portions.

In accordance with a preferred exemplary embodiment of the first and second aspects, the portions of the clamping portion that come into abutting contact with the printed circuit board are planes extending in parallel with the faces of the printed circuit board.

In accordance with a preferred exemplary embodiment of the first and second aspects, a bridging portion connecting clamping portions disposed on respective ones of both faces of the printed circuit board has bent portions at respective faces of the printed circuit board, wherein angles formed by the bent portions in a plane perpendicular to the faces of the printed circuit board are acute angles.

In accordance with a preferred exemplary embodiment of the first and second aspects, the correcting fitting is formed from a single metal plate.

In accordance with a preferred exemplary embodiment of the first and second aspects, the correcting fitting is formed from a resin.

In accordance with a third aspect of the present invention, there is provided a printed circuit board unit, which has a printed circuit board, inserted into and withdrawn from a device in a direction extending along faces of the printed circuit board, the printed circuit board unit having a correcting fitting clamped by elasticity at least on one part of an edge portion of the printed circuit board extending in the direction of insertion and withdrawal for correcting warpage or flexure of the printed circuit board, the correcting fitting having a clamping portion for coming into band-shaped abutting contact with both faces of the printed circuit board along the edge portion of the printed circuit board, wherein the clamping portion is bent in such a manner that at least a portion thereof is directed toward the edge portion of the printed circuit board.

In accordance with a third aspect of the present invention, there is provided a printed circuit board unit, which has a printed circuit board, inserted into and withdrawn from a device in a direction extending along faces of the printed circuit board, the printed circuit board unit having a correcting fitting clamped by elasticity at least on one part of an edge portion of the printed circuit board extending in the direction of insertion and withdrawal for correcting warpage or flexure of the printed circuit board, the correcting fitting having a clamping portion for coming into band-shaped abutting contact with both faces of the printed circuit board along the edge portion of the printed circuit board, wherein the clamping portion is thicker than other portions.

In accordance with a preferred exemplary embodiment of the third and fourth aspects, the printed circuit board is devoid of a fixing element for attaching the correcting fitting to the printed circuit board.

### EFFECTS OF THE INVENTION

The present invention has at least one of effects set forth below.

By virtue of the foregoing, the correcting fitting of the present invention is such that a pair of plate surfaces can be fitted onto a board member while maintaining a fixed strength owing to spring action. As a result, the correcting fitting of the present invention will not fall off the printed circuit board even though the correcting fitting of the present invention is not fixed to the printed circuit board by rivets or screws.

Further, by forming portions of the plate surfaces of the correcting fitting in such a manner that they are folded in the direction of the edge portion of the printed circuit board, the plate-shaped member becomes multi-layered and bends are formed at a plurality of locations. As a result, the strength (resistance) of the correcting fitting against "bending" can be improved by a wide margin. This means that a desired bending strength can be obtained even if the metal member forming the correcting fitting is made small in thickness.

Further, the portions of the plate surfaces that contact the printed circuit board, which plate surfaces clamp from both sides the board member that forms a side of the printed circuit board, are formed to be thicker than other portions. As a result, the strength of the correcting fitting against "bending" can be improved by a wide margin and it is possible to achieve a strength comparable to that of a correcting fitting made of metal even if the correcting fitting is one made of synthetic resin.

Further, by forming a bent portion having a bend angle that forms a right angle or acute angle in a plane perpendicular to the faces of the printed circuit board, the bending strength of the correcting fitting can be raised further. Furthermore, by making planar the portions that come into abutting contact with the faces of the printed circuit board (i.e., by bringing the correcting fitting and the printed circuit board into band-shaped surface contact), the effect of preventing warpage or flexure of the printed circuit board is enhanced and, owing to the larger surface area, it can be made more difficult for the correcting fitting to become detached from the printed circuit board.

The correcting fitting of the present invention can also be formed by a shaped (or molded) material of synthetic resin. As a result, since the correcting fitting itself is an insulator, it is no longer necessary to consider interference between the correcting fitting and the electronic circuit formed on the printed circuit board and it is possible to form the electronic circuit up to the portion where the printed circuit board contacts the correcting fitting. In comparison with a case where use is made of a correcting fitting made of metal, therefore, high-density packaging of the printed circuit board can be achieved.

In accordance with the present invention, flexure and warpage are prevented by clamping and holding the board member, which forms a side of the printed circuit board, by the correcting fitting serving as a reinforcing member (or the correcting fitting made of synthetic resin). Flexure and warpage of the printed circuit board can therefore be prevented by fitting the correcting fittings onto two opposite sides of the printed circuit board without the use of screws or rivets, and attaching of the correcting fittings can be performed in simple fashion. Owing to the fact that screws and rivets are not used, the number of parts and the number of assembly steps can be reduced. This makes it possible to lower the cost of the printed circuit board.

Further, it is unnecessary to provide the printed circuit board with holes and the mounting area of the correcting fitting serving as a reinforcing member can be reduced. As a result, high-density packaging of the printed circuit boards can be achieved.

Further, in the background art, there is the possibility that flexure or warpage will be not be suppressed fully owing to the plate thickness of the metal, etc., in a case where flexure or warpage of the printed circuit board is severe or in a case where a large load is applied when a card is inserted. According to the proposal of the present invention, however, the strength of the correcting fitting can be improved by specially contriving the shape of the metal. This makes it possible to solve the problem that arises in the background art.

### BRIEF DESCRIPTION OF THE DRAWINGS

Fig. 1 is a schematic perspective view illustrating a correcting fitting and a printed circuit board unit according to a first exemplary embodiment of the present invention;
Fig. 2 is a schematic plan [sic. end] view of a correcting fitting according to a first exemplary embodiment of the present invention;
Fig. 3 is a schematic partially enlarged plan [sic. end] view of a correcting fitting and a printed circuit board unit according to a second exemplary embodiment of the present invention;
Fig. 4 is a schematic partially enlarged plan [sic. end] view of a correcting fitting and a printed circuit board unit according to a third exemplary embodiment of the present invention;
Fig. 5 is a schematic partially enlarged plan [sic. end] view of a correcting fitting and a printed circuit board unit according to a fourth exemplary embodiment of the present invention;
Fig. 6 is a schematic partially enlarged plan [sic. end] view of a correcting fitting and a printed circuit board unit according to a fifth exemplary embodiment of the present invention;
Fig. 7 is a schematic partially enlarged plan [sic. end] view of a correcting fitting and a printed circuit board unit according to a sixth exemplary embodiment of the present invention;
Fig. 8 is a schematic partially enlarged plan [sic. end] view of a correcting fitting and a printed circuit board unit according to a seventh exemplary embodiment of the present invention;
Fig. 9 is a schematic partially enlarged plan [sic. end] view of a correcting fitting and a printed circuit board unit according to an eighth exemplary embodiment of the present invention;
Fig. 10 is a schematic plan [sic. end] view of a correcting fitting for describing a mode of bending a correcting fitting according to the first exemplary embodiment of the present invention;
Fig. 11 is a schematic partially enlarged plan [sic. end] view of a correcting fitting and a printed circuit board unit according to a ninth exemplary embodiment of the present invention;
Fig. 12 is a schematic plan [sic. end] view illustrating the arrangement of an ordinary communication device and shelves;
Fig. 13 is a schematic perspective view for describing installation of cards in a shelf; and
Fig. 14 is a schematic perspective view for describing a printed circuit board unit and a reinforcing fitting of a printed circuit board according to the background art.

### DESCRIPTION OF REFERENCE SYMBOLS

1 card
2 printed circuit board unit
3 printed circuit board
3a edge portion
4 front panel
5, 6, 7, 8, 9, 10, 11, 12 correcting fitting
5a, 6a, 7a, 8a, 9a, 10a, 11a, 12a, 13a clamping portion
5b, 6b, 7b, 8b, 9b, 10b, 11b, 12b, 13b contact surface
5c, 6c, 7c, 8c, 9c, 10c, 11c, 12c, 13c bridging portion
5d, 6d, 7d, 8d, 10d, 11d, 12d, 13d bent portion
21 card
22 printed circuit board unit
23 printed circuit board
24 front panel
25 reinforcing fitting
26 screw or rivet
31 communication device
32 shelf

### PREFERRED MODES FOR CARRYING OUT THE INVENTION

The present invention is a fitting provided on a printed circuit board and having a pair of plate surfaces that embrace (sandwitch) from both sides a board member that forms a side of the printed circuit board. At such time a gap at a portion of the pair of plate surfaces where the surfaces are closest together is formed to be smaller than the thickness of the board member.

Accordingly, the fitting of the present invention is such that the pair of plate surfaces can be fitted onto the board member while maintaining a fixed strength owing to spring action. As a result, the fitting of the present invention will not fall off the printed circuit board even though the fitting of the present invention is not fixed to the printed circuit board by rivets or screws.

Further, by forming portions of the plate surfaces in such a manner that they are folded substantially at a right angle with respect to the faces of the printed circuit board, the strength (resistance) of the fitting against "bending" can be improved by a wide margin. This means that a desired bending strength can be obtained even if the metal member forming the fitting is made small in thickness.

Furthermore, portions of the folded plate surfaces are substantially parallel to the surfaces of the printed circuit board and are formed so as to be folded in a direction pointing toward the side edge of the printed circuit board, whereby the strength of the fitting against "bending" can be further improved by a large extent.

As a result, strength can be improved by a large extent in comparison with the proposal disclosed by Patent Document 4 or 6.

Further, the present invention can be viewed from the standpoint of a printed circuit board. That is, the present invention is a printed circuit board having a quadrilateral shape and equipped with fittings on two opposite sides (side edges) of the quadrilateral, the fittings covering a part of or all of the respective side(s). Each fitting has a pair of plate surfaces that embrace from both sides a board member that forms a side of the printed circuit board. A gap at a portion of the pair of plate surfaces where the surfaces are closest together is formed to be smaller than the thickness of the board member. Portions of the plate surfaces are formed in such a manner that they are folded substantially at a right angle with respect to the surfaces of the printed circuit board.

Furthermore, portions of the folded plate surfaces of the fitting are substantially parallel to the surfaces of the printed circuit board and can be formed so as to be folded in a direction pointing toward the side edge of the printed circuit board.

Further, it is possible to adopt a jig in which the fitting of the present invention is replaced by a shaped (or molded) material of synthetic resin. Specifically, the present invention is a jig made of synthetic resin provided on a printed circuit board and having a pair of plate surfaces that embrace from both sides a board member that forms a side edge of the printed circuit board. A gap at a portion of the pair of plate surfaces where the surfaces are closest together is formed to be smaller than the thickness of the board member. Portions of the plate surfaces that contact the printed circuit board, which plate surfaces embrace from both sides the board member that forms a side edge of the printed circuit board, are formed to have a thickness greater than that of other portions.

In accordance with this arrangement, since the jig itself is an insulator, it is no longer necessary to consider interference between the jig and the electronic circuit formed on the printed circuit board and it is possible to form the electronic circuit up to the portion where the printed circuit board contacts the jig. In comparison with a case where use is made of a fitting made of metal, therefore, high-density packaging of the printed circuit boards can be achieved.

Further, in the case of a jig made of synthetic resin, portions of the plate surfaces that contact the printed circuit board, which plate surfaces embrace from both sides the board member that forms a side edge of the printed circuit board, are formed to have a thickness greater than that of other portions. As a result, the strength of the jig made of synthetic resin can be made a strength comparable to that of a fitting made of metal.

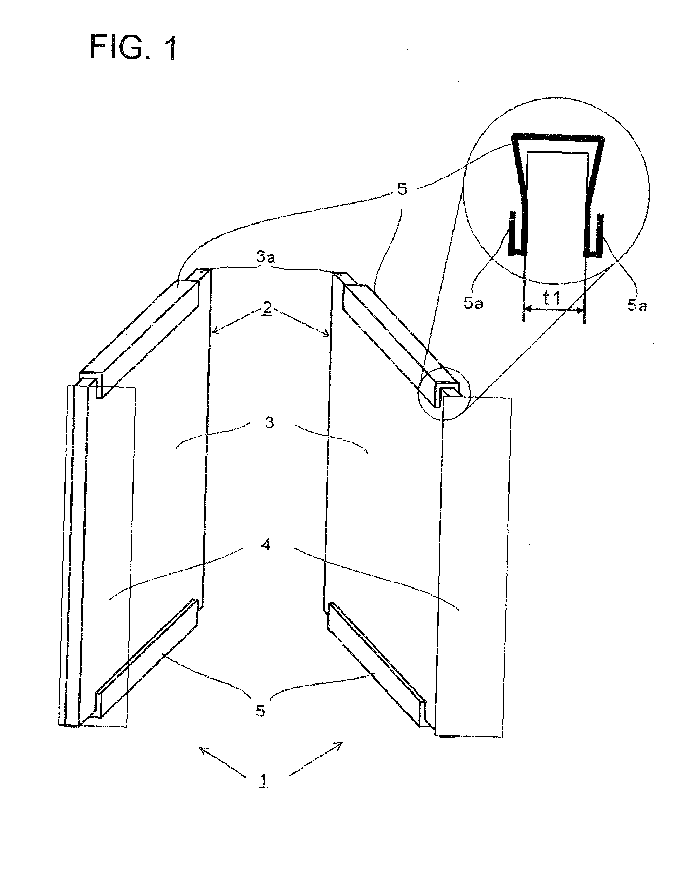

A correcting fitting and printed circuit board unit according to a first exemplary embodiment of the present invention will be described. Fig. 1 is a schematic perspective view illustrating a correcting fitting and a printed circuit board unit according to a first exemplary embodiment of the present invention. In Fig. 1, the correcting fitting and printed circuit board unit are illustrated in the form of a card installed in a shelf of a communication device, by way of example. In order to illustrate both faces of the printed circuit board unit, two printed circuit board units are shown. Further, the sectional shape of the correcting fitting perpendicular to the plane of the printed circuit board is illustrated by a partially enlarged view of a clamping portion of the correcting fitting.

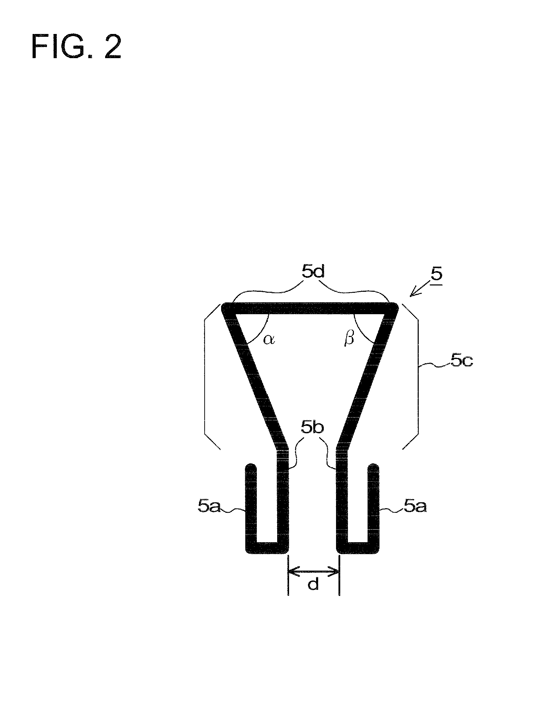

The details of a card 1 are shown in Fig. 1. In Fig. 1, the card 1 is constituted by a printed circuit board unit 2 on which an electronic circuit has been mounted, and a front panel 4 for protecting an LED and connector, etc., on the front portion of the card 1 and for presenting an explanatory display. The printed circuit board unit 2 has a printed circuit board 3 and correcting fittings 5 for preventing flexure and warpage of the printed circuit board 3. The correcting fitting 5 has an insertion width d (Fig. 2) smaller by a prescribed amount than thickness t1 of the printed circuit board 3. The correcting fitting 5 is further provided with folded-back portions in order to enhance the function for preventing warpage and flexure of the correcting fitting. The card 1 is inserted into and withdrawn from a shelf of a communication device, etc., along a direction extending along the faces of the printed circuit board 3.

The correcting fitting 5 corrects warpage and flexure of the printed circuit board 3. The correcting fitting 5 is clamped by elasticity at least on one part of at least one edge portion 3a of the printed circuit board 3 along the direction of insertion and withdrawal of the printed circuit board 3 and comes into band-shaped abutting contact with both faces of the printed circuit board 3. In the configuration shown in Fig. 1, correcting fittings are fitted onto both upper and lower edge portions 3a of the printed circuit board 3. Although the correcting fitting 5 may be fitted over the entire length of the edge portion 3a of the printed circuit board 3, it need not be fitted over the entire length of the edge portion 3a of the printed circuit board 3, as shown in Fig. 1. It will suffice if the length of the correcting fitting 5 is made large enough so that the printed circuit board 3 will not undergo warpage or flexure when the card 1 is inserted and withdrawn.

Fig. 2 is a schematic plan [sic. end] view of the correcting fitting 5 of Fig. 1 in a state in which it has not been fitted onto the printed circuit board 3. The correcting fitting 5 has contact faces 5b that come into abutting contact with respective ones of both faces of the printed circuit board 3. Each contact face 5b defines a plane, which extends in parallel with the faces of the printed circuit board 3, in such a manner that the contact face comes into band-shaped surface contact with the printed circuit board 3. As a result, the correcting effect on the printed circuit board 3 can be enhanced in comparison with a case where the contacting portions of the correcting fitting 5 and printed circuit board 3 define a line, and it is more difficult for the correcting fitting 5 to become detached from the printed circuit board 3.

In the state in which the correcting fitting 5 is not fitted onto the printed circuit board 3, the gap d between the contact faces 5b is smaller than thickness t1 of the printed circuit board. The correcting fitting 5 is formed from a material exhibiting elasticity. By spreading the gap between the contact surfaces 5b, the correcting fitting 5 clamps onto the printed circuit board 3 owing to this elasticity. Accordingly, an area for fixing the correcting fitting 5 to the printed circuit board 3 (e.g., an area for mounting fixing elements such as screws or rivets) is unnecessary and size can be reduced in comparison with a printed circuit board that uses such fixing elements. Further, a step for mounting the fixing elements can be eliminated.

The correcting fitting 5 is equipped with clamping portions 5a having the contact faces 5b that come into band-shaped abutting contact with both faces of the printed circuit board 3 along the edge portion 3a of printed circuit board 3. Each clamping portion 5a is bent in such a manner that at least a portion thereof is directed toward the edge portion 3a of the printed circuit board 3. In the correcting fitting 5 on the upper portion of the printed circuit board 3 shown in the partially enlarged view of Fig. 1, the clamping portions 5a of the correcting fitting 5 are folded away from the faces of the printed circuit board 3 and in the upward direction. Specifically, the clamping portions 5a are valley-folded to form a valley (or two times valley-folded) away from the faces of the printed circuit board 3. As a result, each clamping portion 5a of the correcting fitting 5 is formed into a doubled portion and the correcting fitting 5 clamps the printed circuit board 3 at the doubled portions.

Since the doubled portions of the printed circuit board 3 make it difficult for the correcting fitting 3 to become deformed in the direction of warpage or flexure of the printed circuit board 3, warpage and flexure of the printed circuit board 3 can be prevented even if stress is applied when the card 1 is inserted and withdrawn.

The clamping portions 5a of the correcting fitting 5 disposed on respective ones of both faces of the printed circuit board 3 are connected by a bridging portion 5c that extends so as to span both faces of the printed circuit board 3. The bridging portion 5c is formed to have bent portions 5d at respective ones of both faces of the printed circuit board 3. Angles α, β formed by the bent portions 5d in a plane perpendicular to the faces of the printed circuit board 3 are acute angles (the angles may rounded). Since it can be made difficult for the correcting fitting 5 to become deformed in the direction of warpage or flexure of the printed circuit board 3 also by making the bent portions 5d acute angles, warpage and flexure of the printed circuit board 3 can be prevented even if stress is applied when the card 1 is inserted and withdrawn.

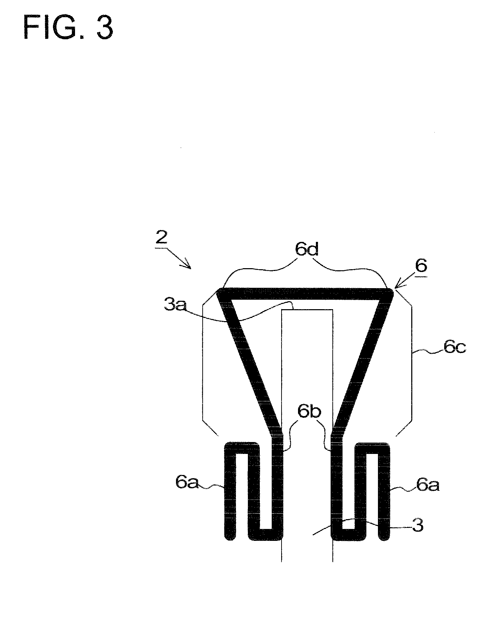

Next, correcting fittings and printed circuit board units according to second to eighth exemplary embodiments of the present invention will be described. Figs. 3 to 9 are schematic partially enlarged plan [sic. end] views of printed circuit board units for describing correcting fittings and printed circuit board units according to second to eighth exemplary embodiments of the present invention. The second to eighth exemplary embodiments are such that the bends of the clamping portions of the correcting fittings are different from those of the first exemplary embodiment. In the second, third, fifth and sixth exemplary embodiments, each clamping portion is formed by folding back a plate-shaped member a plurality of times. In the seventh and eighth exemplary embodiments, each clamping portion is formed by imparting a plate-shaped member with a cylindrical shape. In Figs. 3 to 9, elements identical with those of the first exemplary embodiment are designated by like reference symbols, with the exception of the correcting fitting.

In the second exemplary embodiment shown in Fig. 3, each clamping portion 6a of a correcting fitting 6 is folded repeatedly into alternating valleys and peaks (or at least one time into a series of a valley fold and valley fold and peak fold and peak fold) away from the printed circuit board 3, whereby the clamping portion 6a is folded upon itself multiple times in one direction. As a result, the strength of the correcting fitting 6 against warpage and flexure of the printed circuit board 3 can be enhanced in comparison with the first exemplary embodiment.

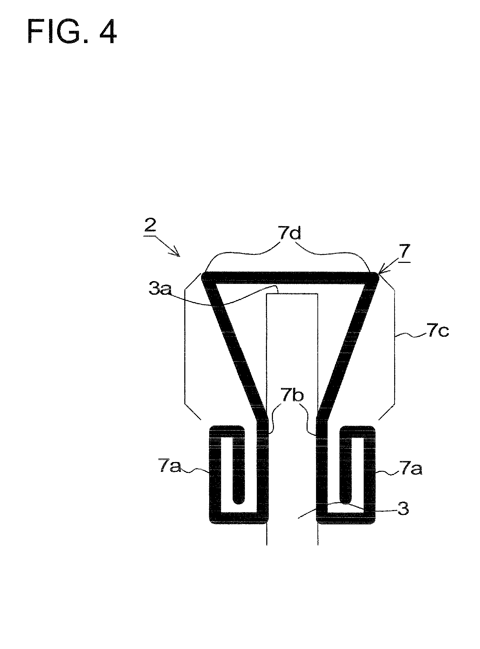

In the third exemplary embodiment shown in Fig. 4, each clamping portion 7a of a correcting fitting 7 is folded upon itself into valleys a plurality of times in the direction of the printed circuit board 3, whereby the clamping portion 7a is folded upon itself multiple times as if being wound. As a result, the strength of the correcting fitting 6 against warpage and flexure of the printed circuit board 3 can be enhanced in comparison with the first exemplary embodiment.

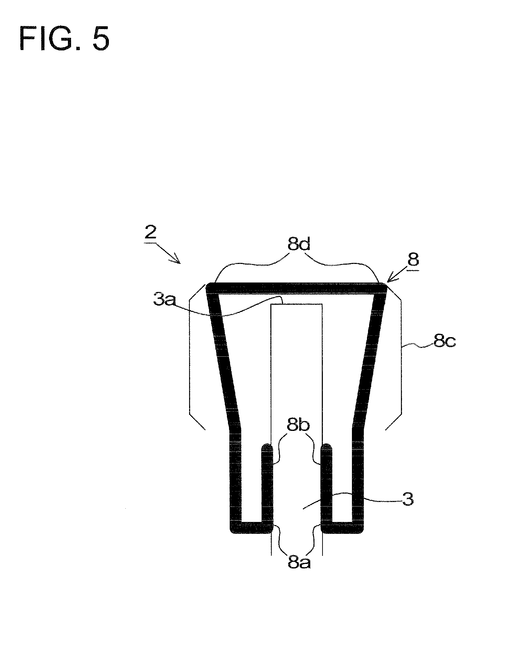

In the fourth exemplary embodiment shown in Fig. 5, the direction in which a clamping portion 8a of a correcting fitting 8 is folded is opposite that of the first exemplary embodiment shown in Figs. 1 and 2. That is, the clamping portion 8a is valley-folded upon itself to form a valley (or two times valley-folded) toward the face of printed circuit board 3. In the fourth exemplary embodiment, the folded-over portion forms a band-shaped contact face 8b by being made a plane that extends in parallel with the faces of the printed circuit board 3.

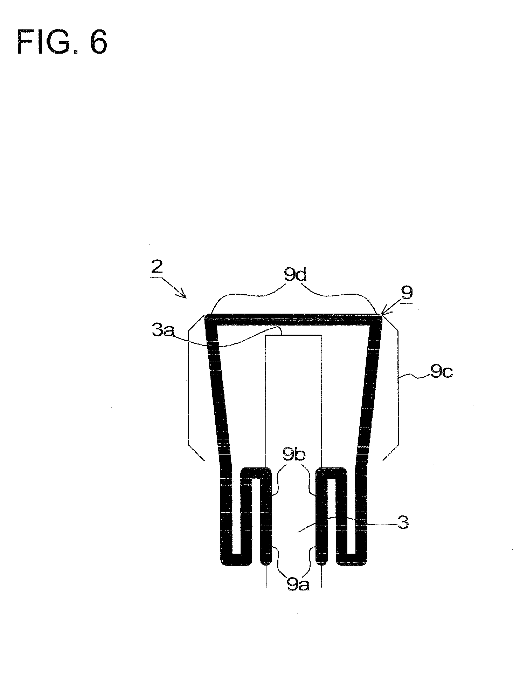

In the fifth exemplary embodiment shown in Fig. 6, the direction in which a clamping portion 9a of a correcting fitting 9 is folded is opposite that of the second exemplary embodiment shown in Fig. 3. That is, the clamping portion 9a is folded repeatedly into alternating peaks and valleys (or at least one time into a series of a peak fold and peak fold and valley fold and valley fold) directed toward the face of the printed circuit board 3. As a result, the strength of the correcting fitting 9 against warpage and flexure of the printed circuit board 3 can be enhanced in comparison with the first exemplary embodiment. In the fifth exemplary embodiment, the folded-over portion forms a contact face 9b by being made a plane that extends in parallel with the faces of the printed circuit board 3.

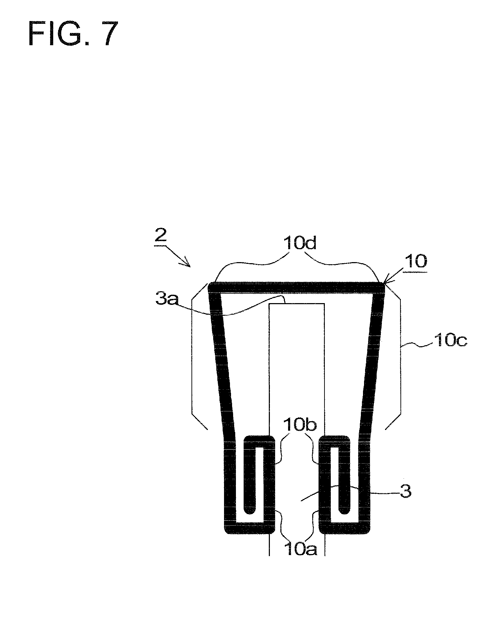

In the sixth exemplary embodiment shown in Fig. 7, the direction in which a clamping portion 10a of a correcting fitting 10 is folded is opposite that of the third exemplary embodiment shown in Fig. 4. That is, the clamping portion 10a is valley-folded upon itself to form valleys a plurality of times in the direction of the printed circuit board 3. As a result, the strength of the correcting fitting 10 against warpage and flexure of the printed circuit board 3 can be enhanced in comparison with the first exemplary embodiment. In the sixth exemplary embodiment, the folded-over portion forms a band-shaped contact face 10b by being made a plane that extends in parallel with the faces of the printed circuit board 3.

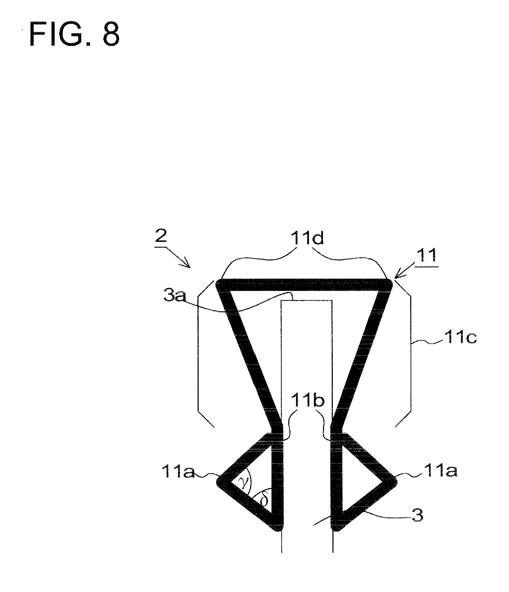

In the seventh exemplary embodiment shown in Fig. 8, bending is such that a cylindrical shape is formed by a clamping portion 11a (closure is not necessary). In the seventh exemplary embodiment, the clamping portion 11a of a correcting fitting 11 is valley-folded twice away from the face of printed circuit board 3, and the clamping portion 11a is bent so as to form a triangular shape one side of which constitutes a contact face 11b in a plane perpendicular to the faces of the printed circuit board 3. In this case, a bend angle δ on the side of the contact face 11b preferably is 90 degrees or less. Further, a bend angle γ on the outer side may be an obtuse angle but preferably is 90 degrees or less. Owing to the fact that a peak is formed along the correcting fitting 11 by the bend forming the bend angle γ, the strength of the correcting fitting can be improved over that of the first exemplary embodiment.

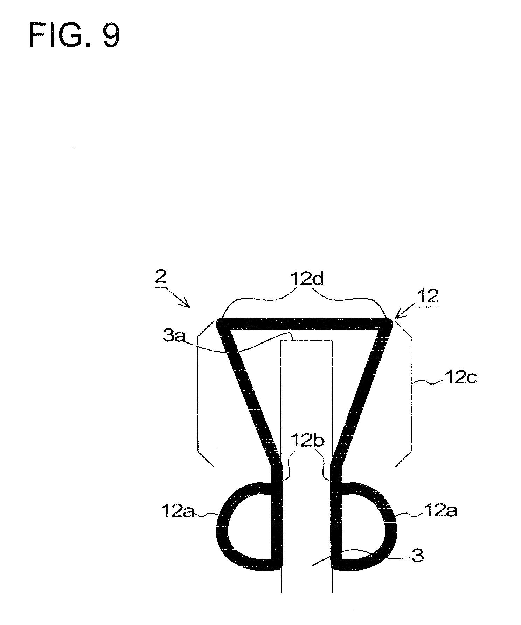

In the eighth exemplary embodiment shown in Fig. 9, bending is such that a cylindrical shape is formed by a clamping portion 12a (closure is not necessary). In the eighth exemplary embodiment, the clamping portion 12a of a correcting fitting 12 is bent so as to form a curved surface directed away from the face of the printed circuit board 3. The clamping portion 12a is bent so as to form a semicircular shape the diameter of which is a contact face 12b in a plane perpendicular to the faces of the printed circuit board 3. Owing to the fact that the peak of the curved surface produced by the clamping portion 12a is formed along the correcting fitting 12, the strength of the correcting fitting can be improved over that of the first exemplary embodiment.

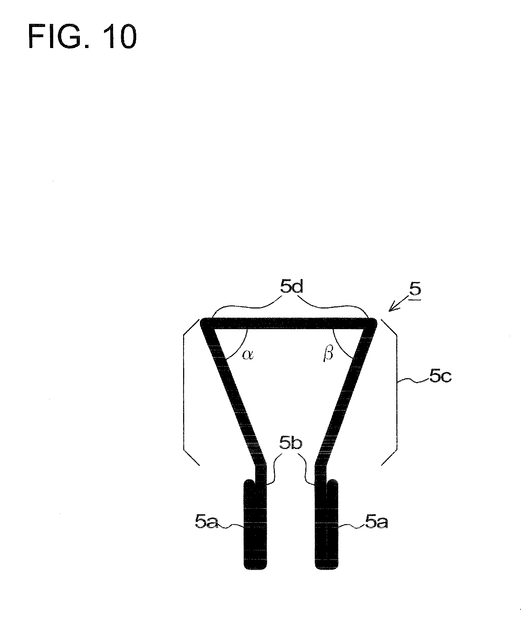

In Figs. 1 to 7 illustrating the first to sixth exemplary embodiments, a gap is illustrated in the folded-over portion of the clamping portion in order to clarify the form of bending in the drawings. (For example, there is a gap between the folded portion and contact face 5b in Fig. 1.) However, the form of bending of the clamping portion in the first to sixth exemplary embodiments may be one in which the gap is provided, as shown in Figs. 1 to 7, or may be one in which the above-mentioned portions are brought into intimate contact so as to eliminate the gap, as in the first [sic. ninth] exemplary embodiment illustrated in Fig. 10. Further, in a case where the clamping portion is, e.g., made double, strength can be enhanced more by making the clamping portion double by bending it twice, as illustrated in Fig. 1, than by bending it once.

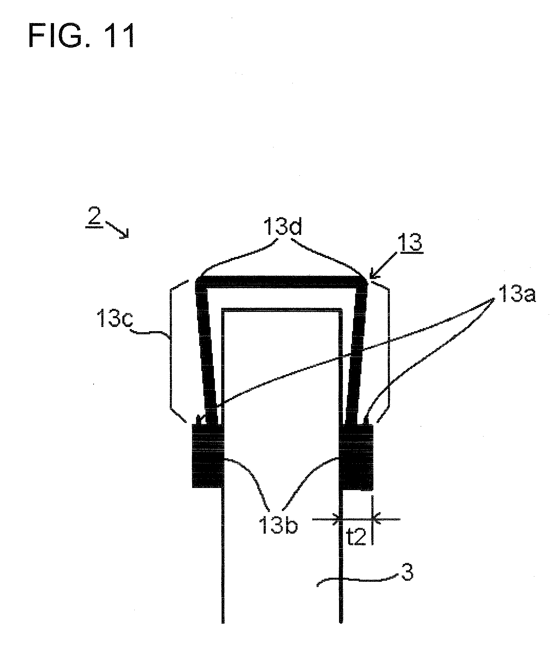

Next, a correcting fitting and printed circuit board unit according to a ninth exemplary embodiment of the present invention will be described. Fig. 11 is a schematic partially enlarged plan [sic. end] view of a printed circuit board unit for describing a correcting fitting and printed circuit board unit according to a ninth exemplary embodiment of the present invention. In Fig. 11, elements identical with those of the first exemplary embodiment are designated by like reference characters, with the exception of the correcting fitting.

In the first to eighth exemplary embodiments, the strength of the correcting fitting is increased by bending the clamping portions of the correcting fitting. In the ninth exemplary embodiment, however, the strength of a correcting fitting 13 is increased by making thickness t2 of clamping portions 13a of the correcting fitting 13 greater than a thickness of a bridging portion 13c that connects the clamping portions 13a disposed on respective ones of both faces of the printed circuit board 3. For example, as shown in Fig. 11, each clamping portion 13a can be formed into a shape of a rectangular parallelepiped, as illustrated in Fig. 11. At this time the shape of the clamping portion 13a preferably is a shape in which a contact surface 13b forms a plane parallel to the faces of the printed circuit board 3.

In the second to ninth exemplary embodiments, the description of the first exemplary embodiment is invoked with regard to matters other than those described above.

The correcting fitting of the present invention can be formed from metal or resin. In particular, the correcting fittings according to the first to eighth exemplary embodiments can readily be formed if a metal plate exhibiting elasticity is bent. Further, the correcting fitting according to the ninth exemplary embodiment can readily be formed into any desired shape and dimensions if a resin is molded.

If the correcting fitting is formed from resin, a short-circuit due to the correcting fitting can be prevented. If signal wiring of a printed circuit board is too close to a metal (e.g., a correcting fitting made of metal) that has been mounted on a printed circuit board, there is the danger that current will jump from the metal to the signal wiring of the printed circuit board and that shorting will be caused when an overcurrent flows into the device. In this case it is required that a fixed distance be maintained between the metal and the signal wiring of the printed circuit board. By forming the correcting fitting from a synthetic resin (an insulator) such as plastic, the signal wiring of the printed circuit board can be laid also below the correcting fitting and an increase in packaging density can be achieved. At this time the insertion portion is thickened as in the manner of a reinforcing-plate thickness 13a in order to increase the strength of the correcting fitting 13, as illustrated in Fig. 11.

The printed circuit board unit of the present invention is suited to packaging in a device such as a communication device, as shown in Fig. 12, used in the card 1 shown in Fig. 1. It should be noted that the construction of the ordinary communication device shown in Fig. 12 is well known among those skilled in the art and, since it is not related directly with the present invention, a detailed description thereof is omitted.

Text, a procedure for mounting the correcting fitting of the present invention on a printed circuit board will be described taking Fig. 1 as an example. In Fig. 1, there are cases where the printed circuit board 3 develops flexure or warpage owing to heating, etc., at the time of mounting of the correcting fitting after an electronic circuit is mounted on the printed circuit board 3. Flexure and warpage are corrected by fitting the correcting fittings 5 onto the upper and lower edges of the printed circuit board 3.

Since the insertion width d (Fig. 2) of the correcting fitting 5 is smaller by a prescribed amount than the thickness t1 of the printed circuit board 3, the printed circuit board 3 is restrained by elasticity at the time of insertion and the correcting fitting 5 will not readily become detached.

In addition, owing to the fact that the correcting fitting 5 has bend(s) or folding-over(s), it is more capable of preventing flexure and warpage, which is ascribable to application of force when the front panel 4 is installed and the completed card 1 inserted into and withdrawn from the shelf 32 (Fig. 12), in comparison with the proposal disclosed by Patent Document 4 or 6, by way of example.

### INDUSTRIAL APPLICABILITY

In accordance with the present invention, the number of parts of a printed circuit board and the number of assembly steps can be reduced, and it is possible to lower the cost of the printed circuit board and to achieve high-density packaging.

Although a correcting fitting and printed circuit board unit according to the present invention have been described based upon the foregoing exemplary embodiments, the invention is not limited to these exemplary embodiments. Within the bounds of the full disclosure of the present invention (inclusive of the claims), it is possible to modify and adjust the modes and exemplary embodiments based upon the fundamental technical idea of the invention. Multifarious combinations and selections of the various disclosed elements are possible within the bounds of the scope of the claims of the present invention. Further problem(s) to be solved, objects and developments of the present invention will become clear from the full disclosure of the present invention inclusive of the scope of the claims.

## Claims

1. A correcting fitting clamped by elasticity at least on one part of an edge portion of a printed circuit board for correcting warpage or flexure of said printed circuit board, **characterized by** having:
a clamping portion for coming into band-shaped abutting contact with both faces of said printed circuit board along said edge portion of said printed circuit board;
wherein said clamping portion is bent in such a manner that at least a portion thereof is directed toward said edge portion of said printed circuit board.

2. A correcting fitting according to claim 1, **characterized in that** said clamping portion is formed by folding back a plate-shaped member a plurality of times.

3. A correcting fitting according to claim 1, **characterized in that** said clamping portion is formed by imparting a plate-shaped member with a cylindrical shape.

4. A correcting fitting clamped by elasticity at least on one part of an edge portion of a printed circuit board for correcting warpage or flexure of said printed circuit board, **characterized by** having:
a clamping portion for coming into band-shaped abutting contact with both faces of said printed circuit board along said edge portion of said printed circuit board;
wherein said clamping portion is thicker than other portions.

5. A correcting fitting according to any one of claims 1 to 4, **characterized in that** portions of said clamping portion that come into abutting contact with said printed circuit board are planes extending in parallel with the faces of the printed circuit board.

6. A correcting fitting according to any one of claims 1 to 5, **characterized in that** a bridging portion connecting said clamping portions, which are disposed on respective ones of both faces of said printed circuit board, has bent portions at respective faces of said printed circuit board;
wherein angles formed by said bent portions in a plane perpendicular to the faces of said printed circuit board are acute angles.

7. A correcting fitting according to claim 1, **characterized by** being formed from a single metal plate.

8. A correcting fitting according to claim 4, **characterized by** being formed from a resin.

9. A printed circuit board unit, which has a printed circuit board, inserted into and withdrawn from a device in a direction extending along faces of said printed circuit board, **characterized by** having:
a correcting fitting clamped by elasticity at least on one part of an edge portion of said printed circuit board extending in the direction of insertion and withdrawal for correcting warpage or flexure of said printed circuit board;
wherein said correcting fitting has a clamping portion for coming into band-shaped abutting contact with both faces of said printed circuit board along said edge portion of said printed circuit board; and
said clamping portion is bent in such a manner that at least a portion thereof is directed toward said edge portion of said printed circuit board.

10. A printed circuit board unit, which has a printed circuit board, inserted into and withdrawn from a device in a direction extending along faces of said printed circuit board, **characterized by** having:
a correcting fitting clamped by elasticity at least on one part of an edge portion of said printed circuit board extending in the direction of insertion and withdrawal for correcting warpage or flexure of said printed circuit board;
wherein said correcting fitting has a clamping portion for coming into band-shaped abutting contact with both faces of said printed circuit board along said edge portion of said printed circuit board; and
said clamping portion is thicker than other portions.

11. The printed circuit board unit according to claim 9 or 10, wherein said correcting fitting is devoid of a fixing element for attaching said correcting fitting to said printed circuit board.
